# EUROPEAN PATENT APPLICATION

(11) **EP 2 998 993 A1**
(43) Date of publication of application: **23.03.2016**
(21) Application number: 15185544.2
(22) Date of filing: 16.09.2015
(51) Int. Cl.: H01L 23/522, H01F 17/00

(54) **CIRCUIT PROTECTION DEVICE AND METHOD OF MANUFACTURING SAME**

(30) Priority: 16.09.2014 KR 20140122781
(71) Applicant: Innochips Technology Co., Ltd., Gyeonggi-Do 15433 (KR)
(72) Inventor: PARK, In Kil, Seongnam-Si (KR); NOH, Tae Hyung, Siheung-Si (KR); JUNG, Jun Ho, Siheung-Si (KR); KIM, Gyeong Tae, Ansan-Si (KR); CHO, Seung Hun, Siheung-Si (KR); KIM, Young Tak, Ansan-Si (KR); PARK, Jong Pil, Ansan-Si (KR)
(74) Representative: Michalski Hüttermann & Partner Patentanwälte mbB

(57) **Abstract**

Provided is a circuit protection device and a method of manufacturing the same including forming a plating lead line and a first coil pattern connected to the plating lead line on a substrate, forming an insulating layer on the first coil pattern and then forming a via hole exposing a portion of the first coil pattern, applying power through a plating lead line to form a via plug filling the via hole from the first coil pattern, and forming a second coil pattern connected to the via plug at an upper portion of the insulating layer.

## Description

### BACKGROUND

The present disclosure relates to a circuit protection device, and more particularly, to a circuit protection device and a method of manufacturing the same in which process reliability may be improved and the number of processes may be reduced.

Recently, a variety of frequency bands are used as a portable electronic device, e.g., a smart phone becomes multi-functional. That is, a single smart phone becomes to have a plurality of functions, such as wireless LAN, Bluetooth, and GPS that use different frequency bands. In addition, internal circuits become denser in a limited space as an electronic device becomes highly integrated and accordingly, interference noise is inevitably generated between the internal circuits.

Therefore, a plurality of circuit protection devices are being used for suppressing noise of a variety of frequencies in a portable electronic device and noise between internal circuits. For example, a condenser, a chip bead, a common mode filter, and the like that eliminate noise in different frequency bands, respectively are being used. Herein, the common mode filter has a structure in which two choke coils are combined in one and may pass a signal current of a differential mode and may eliminate only a noise current of a common-mode. That is, the common mode filter may classify and eliminate the signal current (i.e., alternate current) of a differential mode and the noise current of a common mode. An example of such a common mode filter is presented in Korea Patent Publication No. 2013-0035474.

The common mode filter is required to be miniaturized and highly integrated so as to be used in a major smart phone, etc. Therefore, a thin film type common mode filter is gradually replacing an existing coil-type common mode filter. In the thin film type common mode filter, a coil pattern is formed by electroplating a metal layer. That is, the thin film type common mode filter is manufactured by repeating a process, for a plurality of times, in which a seed layer and a photosensitive layer are formed on a substrate, the photosensitive layer is patterned in a coil shape, an electroplating process is performed to grow a metal layer from the seed layer, the photoresist film pattern is eliminated, and an insulating layer is formed on the metal layer. In addition, a via hole needs to be formed and filled so as to connect a lower coil pattern and an upper coil pattern to each other. To fill the via hole, a seed layer is formed, then a via pattern is formed by a photo process and a development process, then a metal layer is grown by an electroplating process, and then the metal layer and the seed layer formed in a region other than the via hole are eliminated. Thus, since forming a seed layer, a photo process, and a development process need to be performed so as to fill a via hole in a common mode filter of a related art, the process is complicated.

In addition, a step difference is generated between a region on which a coil pattern is formed and a region on which a coil pattern is not formed when the coil pattern is formed of a metal layer. That is, the coil pattern is formed in a shape, for example, rotating from one region in an outward direction, so that a step difference is generated between a center region of the coil pattern and a region on which the coil pattern is not formed and which is adjacent to the center region of the coil pattern. Since the step difference scatters light when a lithography process of a photosensitive layer is performed, accuracy of the lithography process is degraded. Therefore, the photosensitive layer pattern may not be formed in a required shape. In addition, since a planarization process should be performed after an insulating layer is formed so as to eliminate the step difference, the process is complicated due to addition of the planarization process.

### SUMMARY

The present disclosure provides a circuit protection device and a method of manufacturing the same in which a process may be simplified and a step difference may be reduced.

The present disclosure also provides a circuit protection device and a method of manufacturing the same in which a process of forming a seed layer for filling a via hole is not performed by using a lower coil pattern as a seed layer when the via hole is filled.

The present disclosure also provides a circuit protection device and a method of manufacturing the same in which a step difference between a region on which a coil pattern is formed and a region on which a coil pattern is not formed may be reduced by forming a dummy pattern on a region on which a coil pattern is not formed.

In accordance with an exemplary embodiment, a method of manufacturing a circuit protection device includes forming a plating lead line and a first coil pattern connected to the plating lead line on a substrate, forming an insulating layer on a first coil pattern and then forming a via hole exposing a portion of the first coil pattern, applying power through a plating lead line to form a via plug filling the via hole from the first coil pattern, and forming a second coil pattern connected to the via plug on the insulating layer.

The plating lead line may be formed in plurality on the substrate in one direction and in another direction perpendicular to the one direction.

At least one coil pattern may be stacked on the second coil pattern in a vertical direction and the plurality of coil patterns stacked in the vertical direction may be arranged in plurality inside a region between the plating lead lines in a horizontal direction.

The plating lead line may be formed so as to overlap a cutting line for cutting the substrate into unit devices.

The plating lead line may be eliminated together with the cutting line when the substrate on which the coil pattern is formed is cut into the unit devices.

The method of manufacturing a circuit protection device may further include forming an ESD protection part insulated from the coil pattern of the lowest layer or the uppermost layer under the coil pattern of the lowest layer or on the coil pattern of the uppermost layer.

The method of manufacturing a circuit protection device may further include forming a dummy pattern spaced apart from at least one of the coil patterns.

The dummy pattern may be formed on a region on which the coil pattern is not formed.

In accordance with another exemplary embodiment, a circuit protection device include a plurality of coil patterns stacked on a substrate in a vertical direction, a plurality of insulating layers each formed between the plurality of coil patterns and insulating the plurality of coil patterns, a plurality of via plugs formed in the plurality of insulating layers and connecting the plurality of coil patterns to each other, and a dummy pattern formed in at least one coil pattern, wherein the via plugs are formed by filling a via hole provided in the insulating layer from the coil pattern of a lower layer by applying power through a plating lead line connected to at least one of the coil patterns.

The dummy pattern may be formed on a region on which the coil pattern is not formed.

The method of manufacturing a circuit protection device may further include an ESD protection part formed under the lowest insulating layer or on the uppermost insulating layer.

### BRIEF DESCRIPTION OF THE DRAWINGS

Exemplary embodiments can be understood in more detail from the following description taken in conjunction with the accompanying drawings, in which:
FIG. 1 is a plan view of a circuit protection device in a manufacturing process in accordance with an exemplary embodiment;
FIGS. 2 to 10 are cross sectional views sequentially illustrated to describe a method of manufacturing a circuit protection device in accordance with an exemplary embodiment;
FIG. 11 is a cross sectional view of a circuit protection device in accordance with a modified exemplary embodiment;
FIG. 12 is a plan view of a circuit protection device in a manufacturing process in accordance with another exemplary embodiment;
FIGS. 13 to 20 are cross sectional views sequentially illustrated to describe a method of manufacturing a circuit protection device in accordance with another exemplary embodiment;
FIG. 21 is a plan view of a circuit protection device in a manufacturing process in accordance with another modified exemplary embodiment; and
FIG. 22 is a cross sectional view of a circuit protection device in accordance with a still another exemplary embodiment.

### DETAILED DESCRIPTION OF EMBODIMENTS

Hereinafter, exemplary embodiments of the inventive concept will be described in detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. Further, the present invention is only defined by scopes of claims.

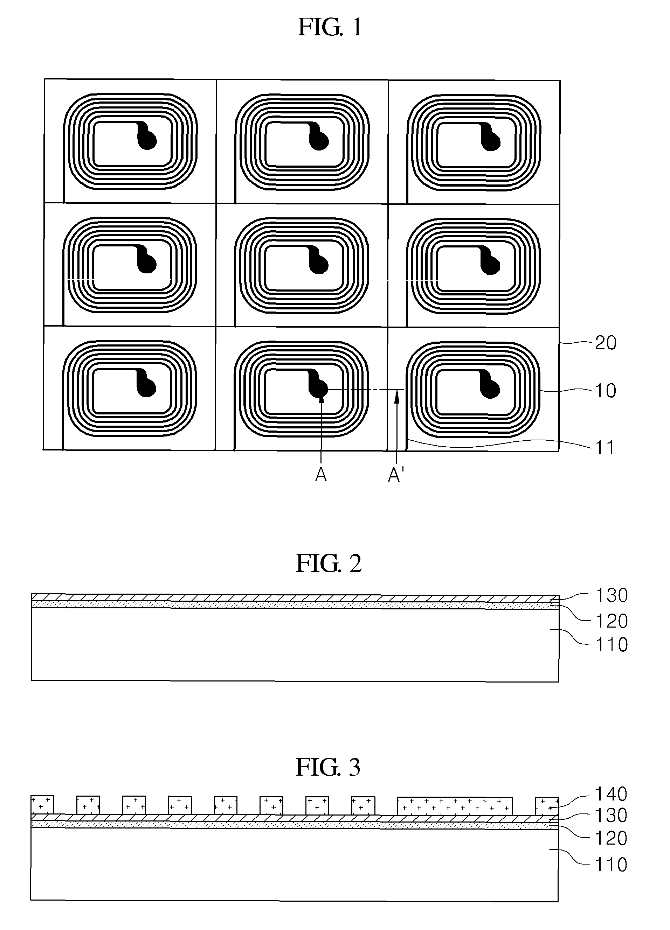

FIG. 1 is a plan view of a circuit protection device in a manufacturing process in accordance with an exemplary embodiment and FIGS. 2 to 10 are cross sectional views sequentially illustrated taken along line A-A' in FIG. 1 to describe a method of manufacturing a circuit protection device in accordance with an exemplary embodiment.

Referring to FIG. 1, a plurality of coil patterns 10 are formed on a substrate and the coil patterns 10 are formed, for example, in a shape wound a plurality of times while rotating in one direction, i.e., a spiral form. The coil pattern 10 is provided in plurality at an equal interval in one direction and another direction perpendicular to the one direction. In addition, at least two of the coil patterns 10 may be stacked in a vertical direction. That is, at least two of the coil patterns 10 are stacked in the vertical direction and the stacked type coil patterns 10 may be arranged in plurality in a horizontal direction. Meanwhile, an extension line 11 extends from the coil pattern 10 in one direction is provided on an outmost portion of the coil pattern 10. That is, the extension line 11 may extend from an end portion farthest from a center portion of at least one of the plurality of coil patterns 10 stacked in the vertical direction, e.g., the coil pattern 10 of the lowest layer in a direction moving apart from the center portion of the coil pattern 10. The extension line 11 is provided so as to deliver an electrical signal and or the like to the coil pattern 10. That is, the extension line 11 may be provided so as to apply driving power to the coil pattern 10 of the unit circuit protection device and to apply power for electroplating when the circuit protection device is manufactured. In addition, a plating lead line 20 is formed between the plurality of coil patterns 10 arranged in the horizontal direction. That is, the plating lead line 20 is formed in plurality in one direction and another direction perpendicular to the one direction, and the substrate may be partitioned into a plurality of regions by the plating lead line 20. Each of the coil patterns 10 is formed on the plurality of regions partitioned by the plating lead line 20. In addition, the plating lead line 20 may be formed when the coil pattern 10 of the lowest layer is formed. The plating lead line 20 is connected to the extension line 11 and power supplied through the plating lead line 20 may be delivered to the coil pattern 10 through the extension line 11. Therefore, when electroplating is performed for forming the coil pattern 10, the plating lead line 20 supplies power to the coil pattern 10 of a lower layer so that the coil pattern 10 of the lower layer is used as a seed layer. That is, when electroplating is performed for filling a via hole configured to connect the coil pattern 10 of the lower layer to the coil pattern 10 of an upper layer, power is supplied through the plating lead line 20 to be able to use the coil pattern of the lower layer 10 as a seed layer. Meanwhile, the plating lead line 20 may be formed in vicinity of a cutting line for cutting the coil patterns 10 into unit devices. For example, the plating lead line 20 may be formed overlapping the cutting line, i.e. a scribe line. In addition, the plating lead line 20 may be formed in a narrower width than the cutting line. The plating lead line 20 is formed in a narrower width than the cutting line and is formed overlapping the cutting line, thus being able to be eliminated when the substrate is cut along the cutting line. That is, the plating lead line 20 may be eliminated while cutting the substrate without an additional process of eliminating the cutting line.

A method of manufacturing a circuit protection device in accordance with an exemplary embodiment will be described with reference to FIGS. 2 to 10 as below. FIGS. 2 to 10 are cross sectional views taken along line A-A' in FIG. 1.

Referring to FIG. 2, a first insulating layer 120 is formed on a substrate 110 and a first seed layer 130 is formed on the first insulating layer 120. The substrate 110 may be an insulating substrate, for example, a substrate made of a material such as aluminum oxide (Al₂O₃), aluminum nitride (AlN), glass, quartz, or ferrite. In addition, the first insulating layer 120 may be formed of any one selected from polyimide, an epoxy resin, benzocyclobutene (BCB), or other polymers. Also, the first seed layer 130 may be formed of a metal material selected from any one of Ag, Pd, Al, Cr, Ni, Ti, Au, Cu, Pt, or an alloy thereof, for example.

Referring to FIG. 3, a first photosensitive layer 140 is formed on the first seed layer 130 and then a photo process and a development process are performed by using a predetermined mask to pattern the first photosensitive layer 140. The first photosensitive layer 140 may be patterned in a shape, for example, of the coil pattern 10 and the plating lead line 20 in FIG. 1. That is, the first photosensitive layer 140 may be patterned in a shape in which a coil pattern 10 forming region, an extension line 11 forming region, and a plating lead line 20 forming region are eliminated, and a remaining region remains. Herein, the plating lead line 20 forming region may be provided in plurality so as to be spaced apart from each other at an equal interval in one direction and another direction, the coil pattern 10 forming region may be provided in a shape rotating from one region between plating lead line 20 forming regions in an outward direction, i.e. a spiral shape, and the extension line 11 forming region may be provided so as to connect an edge of the coil pattern 10 forming region to the plating lead line 20 forming region.

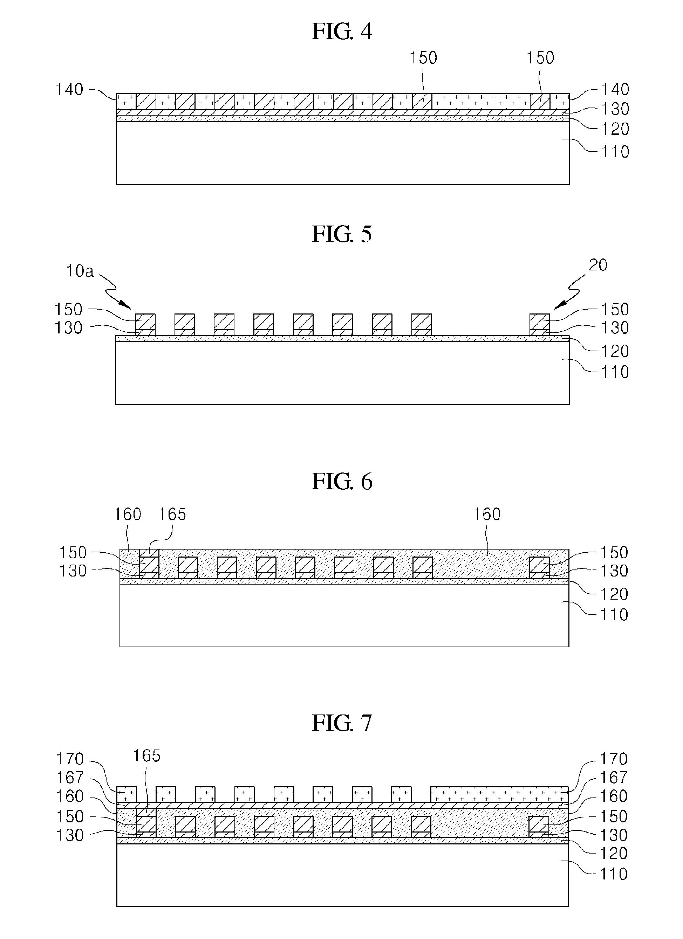

Referring to FIG. 4, an electroplating process is performed to grow a first metal layer 150. The first metal layer 150 is grown from the first seed layer 130 and may be formed in accordance with the shape of the patterned first photosensitive layer 140. That is, the first metal layer 150 is grown from the first seed layer 130 exposed by the patterned first photosensitive layer 140, and the coil pattern having a spiral shape, the plating lead line having a straight line shape, and the extension line between the coil pattern and the plating lead line may be formed in accordance with the pattern shape of the first photosensitive layer 140. Herein, the first metal layer 150 may be formed of any one selected from Ag, Pd, Al, Cr, Ni, Ti, Au, Cu, Pt, or an alloy thereof. That is, the first metal layer 150 may be formed of a same material as the first seed layer 130.

Referring to FIG. 5, the first metal layer 150 is formed by an electroplating process and then the patterned first photosensitive layer 140 is eliminated and the first seed layer 140 exposed by the first metal layer 150 is removed to expose the first insulating layer 120. In this way, a first coil pattern 10a, the extension line 11, and the plating lead line 20 are formed by the first metal later 150 as illustrated in FIG. 1. That is, as illustrated in FIG. 1, the plating lead line 20 is formed in plurality so as to be spaced apart from each other at a predetermined interval in one direction and another direction, the first coil pattern 10a is formed in plurality in a region between the plating lead lines 20, and the extension line 11 is formed in plurality so as to connect the first coil pattern 10a and the plating lead line 20.

Referring to FIG. 6, a second insulating layer 160 is formed on the first metal layer 150 and then a predetermined region of the second insulating layer 160 is etched by a predetermined photo process and a predetermined etching process to form a via hole exposing the first metal layer 150 that is a predetermined region of the first coil pattern 10a. Herein, the second insulating layer 160 may be formed of any one selected from polyimide, an epoxy resin, benzocyclobutene (BCB), or other polymers. That is, the second insulating layer 160 may be formed of a same material as the first insulating layer 120 or may be formed of a material that is different from the first insulating layer 120 and is selected among the foregoing materials. In addition, any region of the first metal layer 150 may become the exposed region of the first metal layer 150 but a center region of the first metal layer 150 is preferably exposed. That is, the first metal layer 150 is exposed so as to expose a center portion of the first coil pattern 10a. Then, a via plug 165 filling the via hole is formed. The via plug 165 may be formed by an electroplating process in which the first metal layer 150 exposed through the via hole is used as a seed. This process is possible since the first metal layer 150 is connected to the plating lead line 20. That is, since power for an electroplating is applied to the first metal layer 150 through the plating lead line 20, the via plug 165 is formed from the first metal layer 150.

Referring to FIG. 7, a second seed layer 167 is formed on the second insulating layer 160, a second photosensitive layer 170 is formed on the second seed layer 167, and then the second photosensitive layer 170 is patterned by an exposure and development process. Herein, the second seed layer 167 may be formed of a same material as the first seed layer 130. In addition, the second photosensitive layer 170 is patterned in accordance with the shape of the first metal layer 150 formed in a coil pattern. That is, the second photosensitive layer 170 is formed so as to expose only a region on which the first coil pattern 10a is formed without exposing a region on which the plating lead line 20 is formed. At this time, since the extension line may be used as an internal electrode connected to an external electrode of a unit circuit protection device, the second photosensitive layer 170 may be formed so as to expose an extension line region.

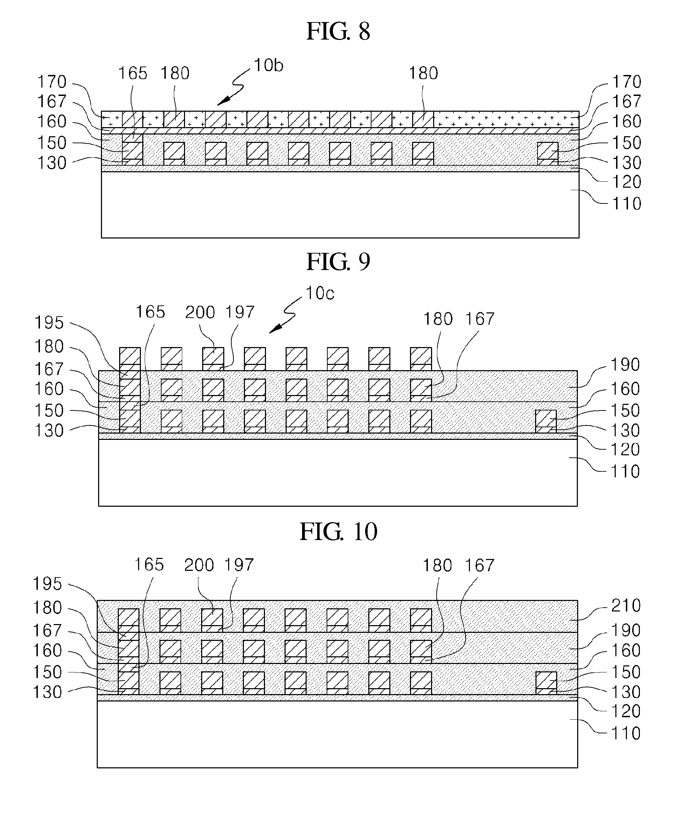

Referring to FIG. 8, a second metal layer 180 is grown from the second seed layer 167 exposed by the second photosensitive layer 170. That is, the second metal layer 180 may be formed by an electroplating process in which the exposed second seed layer 167 is used as a seed. Therefore, a second coil pattern 10b by the second metal layer 180 is formed in a shape that is the same as the shape of the first coil pattern 10a by the first metal layer 150. Of course, the first coil pattern 10a of the lower layer may have a different shape from the second coil pattern 10b of the upper layer. For example, the first coil pattern 10a may be formed so as to rotate in a counterclockwise direction and the second coil pattern 10b may be formed so as to rotate in a clockwise direction.

Referring to FIG. 9, the second photoresist layer 170 is eliminated and the second seed layer 167 exposed by the second metal layer 180 is eliminated to expose the second insulating layer 160. Then, a third insulating layer 190 is formed on the second metal layer 180 and then the third insulating layer 190 is patterned to form a via hole exposing a predetermined region of the second metal layer 180. Then, a via plug 195 filling the via hole is formed by an electroplating process. That is, the via plug 195 may be formed by an electroplating process in which the second metal layer 180 exposed through the via hole is used as a seed. This process is possible since the second metal layer 180 is connected to the plating lead line 20 through the first metal layer 150. That is, since power for an electroplating process is applied to the second metal layer 180 through the plating lead line 20 and the first metal layer 150, the via plug 195 is formed from the second metal layer 180. Then, a third seed layer 197 is formed on the third insulating layer 190, a third photosensitive layer (not shown) is formed on the third seed layer 197, and then the third photosensitive layer is patterned in a same shape as the second photosensitive layer 170. That is, the third photosensitive layer is patterned so that the third insulating layer 190 is exposed in a spiral shape. Then, an electroplating process is performed to grow a third metal layer 200 from the third seed layer 197. At this time, since the third metal layer 200 is formed in a shape by the third photosensitive layer, a third coil pattern 10c by the third metal layer 200 is formed. In addition, a plurality of coil patterns may be stacked as the process is repeated a plurality of times.

Referring to FIG. 10, after the coil patterns are stacked in a predetermined number, an insulating layer 210 is formed on the coil pattern and the substrate is cut into unit devices along the cutting line. At this time, since the plating lead line 20 is formed overlapping the cutting line, the plating lead line 20 is eliminated as the substrate is cut into unit devices.

As described above, in a method of manufacturing a circuit protection device in accordance with an exemplary embodiment, when the first coil pattern 10a of the lowest layer is formed, since the extension line 11 and the plating lead line 20 are formed so as to be connected to the first coil pattern 10a, power may be applied to the plating lead line 20 so that the via plugs 165 and 195 filling via holes may be formed by an electroplating process using the coil pattern 10 under the via hole as a seed. Accordingly, when compared to a related art in which a seed layer and a metal layer should be formed whenever the via plugs 165 and 195 are formed, since the method does not need to form a seed layer, the number of process and process time may be reduced to enhance productivity.

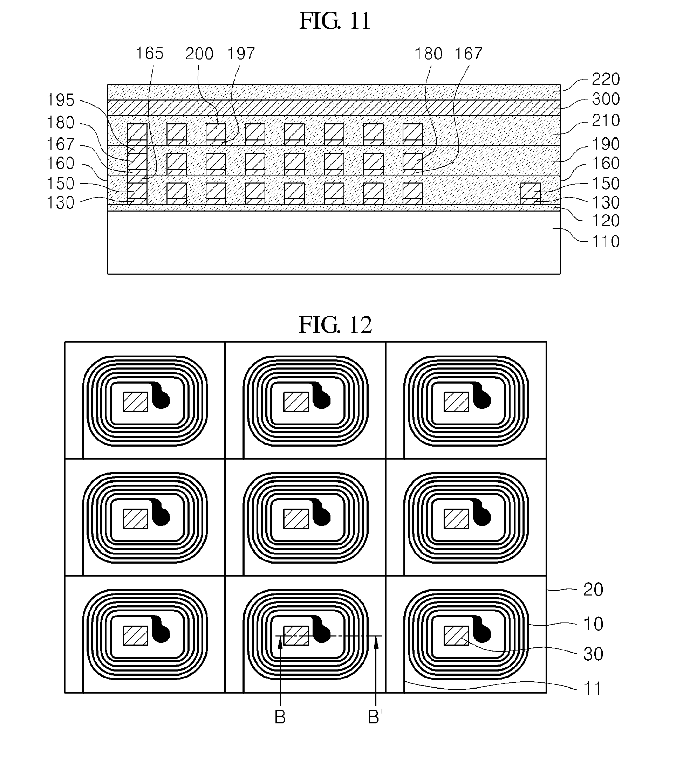

Meanwhile, in the circuit protection devices in accordance with embodiments of the present invention, after the plurality of coil patterns 10 are stacked, an ESD protection part 300 insulated from the coil pattern 10 may be provided above the coil pattern 110. That is, after the coil pattern 10 is stacked in plurality, an insulating layer 210 is formed on the coil pattern 10 as illustrated in FIG. 10 and then the ESD protection part 300 may be formed as illustrated in FIG. 11. In addition, the ESD protection part 300 may be formed between the substrate 110 and the insulating layer 120. That is, the ESD protection part 300 may be formed under the coil pattern 10 of the lowest layer or above the coil pattern 10 of the uppermost layer. Of course, the ESD protection part 300 may be provided both under the coil pattern 10 of the lowest layer and above the coil pattern 10 of the uppermost layer. That is, the ESD protection part 300 may be formed at at least one of under the coil pattern 10 of the lowest layer or above the coil pattern 10 of the uppermost layer. The ESD protection part 300 may be realized by forming an ESD protection material in one direction and another direction. In addition, the ESD protection part 300 may further include an internal electrode configured to connect the ESD protection material to an external electrode. Herein, the ESD protection material may be formed of a mixed material of an organic substance such as polyvinyl alcohol (PVA) or polyvinyl butyral (PVB) with at least one conductive material selected from RuO₂, Pt, Pd, Ag, Au, Ni, Cr, and W. In addition, the ESD protection material may be formed by further mixing the mixed material with a varistor material such as ZnO or an insulating ceramic material such as Al₂O₃. The ESD protection material formed in this way exists in a state in which a conductive material and an insulating material are mixed at a predetermined ratio. That is, conductive particles exist between the insulating materials, when a voltage below a predetermined level is applied to the insulating materials, an insulating state is maintained, or when a voltage above the predetermined level is applied, discharge occurs between the conductive particles. After the ESD protection part 300 is formed in this way, an insulating layer 220 is formed on the ESD protection part 300, and the resultant substrate may be cut into unit devices as illustrated in FIG. 1.

Meanwhile, as illustrated in FIG. 1, a region on which the coil pattern is not formed exists in a center portion of each of the unit devices. A step difference exists between a region on which a coil pattern is formed and a region on which the coil pattern is not formed. That is, a height difference exists between the coil pattern and the insulating layer under the coil pattern. Since the step difference causes reflection of light or the like in a subsequent lithography process, a photosensitive layer may have difficulty in being patterned in a desired shape. A planarization process is required so as to remove the step difference after the insulating layer is formed. Therefore, in another exemplary embodiment, a dummy pattern spaced apart from the coil pattern is formed on a region on which the coil pattern is not formed so as to remove the step difference when a metal layer is patterned. As the dummy pattern is formed, the step difference between the region on which the coil pattern is formed and the region on which the coil pattern is not formed may be reduced or eliminated and accordingly a planarization process is not required. A method of manufacturing a circuit protection device in accordance with another exemplary embodiment will be described with reference to FIGS. 12 to 19 as below.

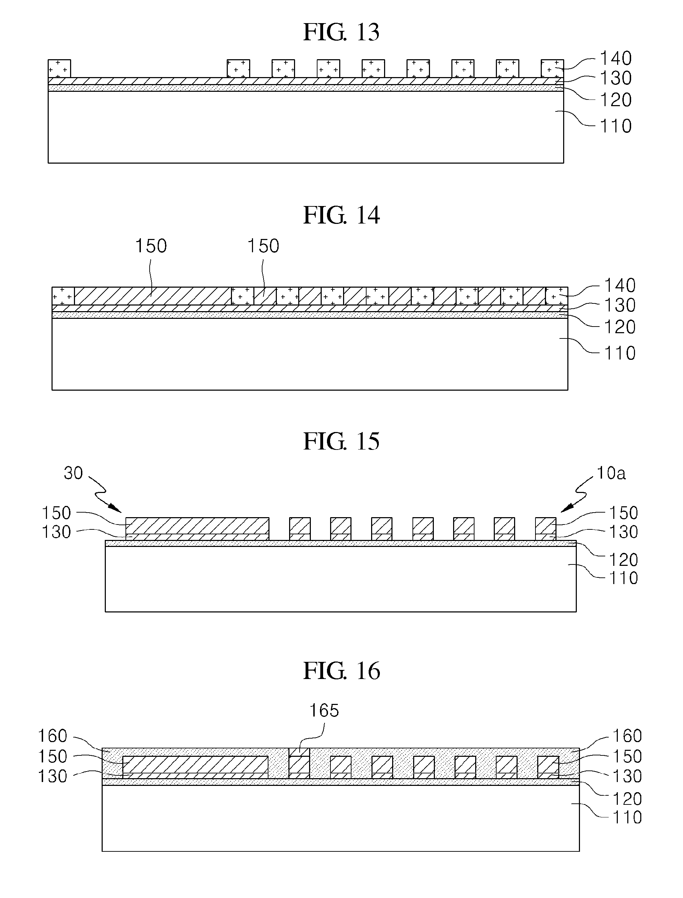

FIG. 12 is a plan view of a circuit protection device in a manufacturing process in accordance with another exemplary embodiment, and FIGS. 13 to 20 are cross sectional views sequentially illustrated taken along line B-B' in FIG. 12 to describe a method of manufacturing a circuit protection device in accordance with another exemplary embodiment.

Referring to FIG. 12, in another exemplary embodiment, a circuit protection device includes a plurality of coil patterns 10, extension lines 11 respectively extending from the plurality of coil patterns 10, a plating lead line 20 extending in one direction and another direction perpendicular to the one direction and connected to the extension line 11, and a dummy pattern 30 provided in a region defined by the plating lead line 20 and provided spaced apart from the plurality of coil patterns 10. The dummy pattern 30 may be provided in a space between a center region of the coil pattern 10 and the once wound coil pattern 10. That is, the coil pattern 10 is formed wound from a center portion of a region defined by the plating lead line 20 in one direction in a spiral shape, and the dummy pattern 30 is formed within a predetermined space existing between the center portion of the coil pattern 10 and the coil pattern10. The dummy pattern 30 is formed spaced apart from, for example, the coil pattern 10 of the lowest layer and an additional dummy pattern may not be formed on the dummy pattern 30. In addition, the dummy pattern 30 may formed by a same process as the coil pattern 10 and may be formed by another process.

A method of manufacturing a circuit protection device in accordance with another exemplary embodiment will be described with reference to FIGS. 13 to 20 as below.

Referring to FIG. 13, a first insulating layer 120 is formed on a substrate 110 and a first seed layer 130 is formed on the first insulating layer 120. The substrate 110 may be an insulating substrate made of a material, for example, of aluminum oxide Al₂O₃, aluminum nitride AlN, glass, quartz, or ferrite. In addition, the first insulating layer 120 may be formed of any one selected from polyimide, an epoxy resin, benzocyclobutene (BCB), or other polymers. In addition, the first seed layer 130 may be formed of any one selected from Ag, Pd, Al, Cr, Ni, Ti, Au, Cu, Pt, or an alloy thereof. Then, a first photosensitive layer 140 is formed on the first seed layer 130 and then a photo process and a development process are performed by using a predetermined mask to pattern the first photosensitive layer 140. The first photosensitive layer 140 is patterned, for example, in a spiral shape from one region so that a predetermined space exists between regions patterned in the spiral shape. That is, the first photosensitive layer 140 is patterned in the shape of the coil pattern 10 in FIG. 12, and is patterned in a rectangular shape on a predetermined region existing between a center region of the coil pattern 10 and an once wound portion of the coil pattern 10, i.e., a region on which a dummy pattern is formed. At this time, a plating lead line 20 forming region and an extension line 11 forming region of the first photosensitive layer 140 may be patterned concurrently with a coil pattern 10 forming region and a dummy pattern forming region.

Referring to FIG. 14, an electroplating process is performed to grow a first metal layer 150. The first metal layer 150 is grown from the first seed layer 130 and may be formed in accordance with the shape of the patterned first photosensitive layer 140. That is, the first metal layer 150 is grown from the first seed layer 130 exposed by the patterned first photosensitive layer 140. Therefore, the first metal layer 150 is formed with a region formed in a spiral shape and a dummy pattern region spaced apart the region formed in the spiral shape.

Referring to FIG. 15, the first metal layer 150 is formed by an electroplating process, then the patterned first photosensitive layer 140 is eliminated, and then the first seed layer 130 exposed by the first metal layer 150 is eliminated to expose the first insulating layer 120. In this way, a first coil pattern 10a is formed in a spiral shape by the first metal later 150, and a dummy pattern 30 is formed spaced apart from a center of the first coil pattern 10a.

Referring to FIG. 16, a second insulating layer 160 is formed on the first metal layer 150 and then a predetermined region of the second insulating layer 160 is etched by a predetermined photo process and a predetermined etching process to form a via hole exposing a predetermined region of the first metal layer 150. Herein, the second insulating layer 160 may be formed of a same material as the first insulating layer 120 or may be formed of any material selected from materials different from the first insulating layer 120. In addition, since the dummy pattern 30 is formed, a step difference between the region on which the coil pattern 10 is formed and the region on which the coil pattern 10 is not formed is eliminated, and thus a planarization process is not required after the second insulating layer 160 is formed. Meanwhile, although any region of the first metal layer 150 may be exposed, a center region of the first metal layer 150, i.e., a center region of the first coil pattern 10a is preferably exposed. Then, an electroplating is performed so that a via plug 165 filling the via hole is formed. The via plug 165 may be formed by an electroplating process in which the first metal layer 150 is used as a seed. This process is possible since the first metal layer 150 is connected to the plating lead line 20. That is, since power for an electroplating process is applied to the first metal layer 150 through the plating lead line 20, the electroplating process is performed to form the via plug 165 from the first metal layer 150.

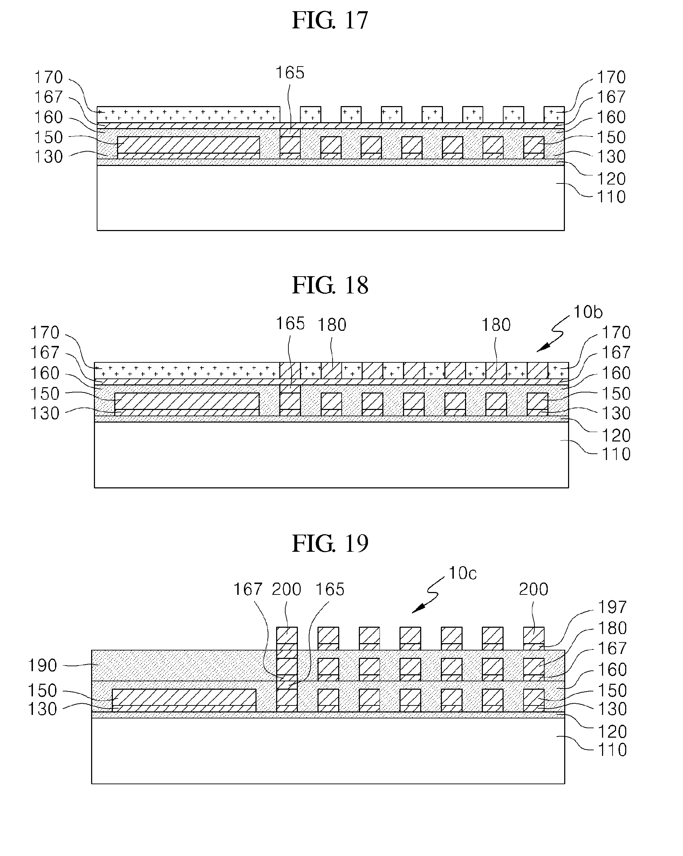

Referring to FIG. 17, a second seed layer 167 is formed on the second insulating layer 160 in which the via plug 165 is formed, a second photosensitive layer 170 is formed on the second seed layer 167, and then the second photosensitive layer 170 is exposed and developed to be patterned. Herein, the second photosensitive layer 170 is patterned in accordance with the shape of the first metal layer 150 formed in the coil pattern.

Referring to FIG. 18, a second metal layer 180 is grown from the second seed layer 167 exposed by the second photosensitive layer 170. That is, the second metal layer 180 may be formed by an electroplating process in which the exposed second seed layer 167 is used as a seed. Therefore, a second coil pattern 10b is formed by the second metal layer 180.

Referring to FIG. 19, the second photoresist layer 170 is eliminated and the second seed layer 167 exposed by the second metal layer 180 is eliminated to expose the second insulating layer 160. In addition, a third insulating layer 190 is formed on the second insulating layer 160 including the second metal layer 180 and then a via hole exposing a predetermined region of the second metal layer 180 is formed by a patterning. A via plug 195 filling the via hole is formed by an electroplating process using the second metal layer 180 as a seed. That is, since the second metal layer 180 is connected to the plating lead line 20 through the first metal layer 150, power is supplied to the second metal layer 180 through the plating lead line 20, so that a metal layer is grown from the second metal layer 180 to form the via plug 195. In addition, a third seed layer 197 is formed on the third insulating layer 190, a third photosensitive layer (not shown) is formed on the third seed layer 197, and then the third photosensitive layer is patterned in a same shape as the second photosensitive layer 170. The third photosensitive layer is patterned so that the third seed layer 197 is exposed in a spiral shape. Then, an electroplating process is performed to grow a third metal layer 200 from the third seed layer 197. In addition, the third photosensitive layer is eliminated and then the third seed layer 197 exposed by the third metal layer 200 is eliminated. Therefore, a third coil pattern 10c is formed by the third metal layer 200. In addition, a plurality of coil patterns may be stacked as the process is repeated a plurality of times.

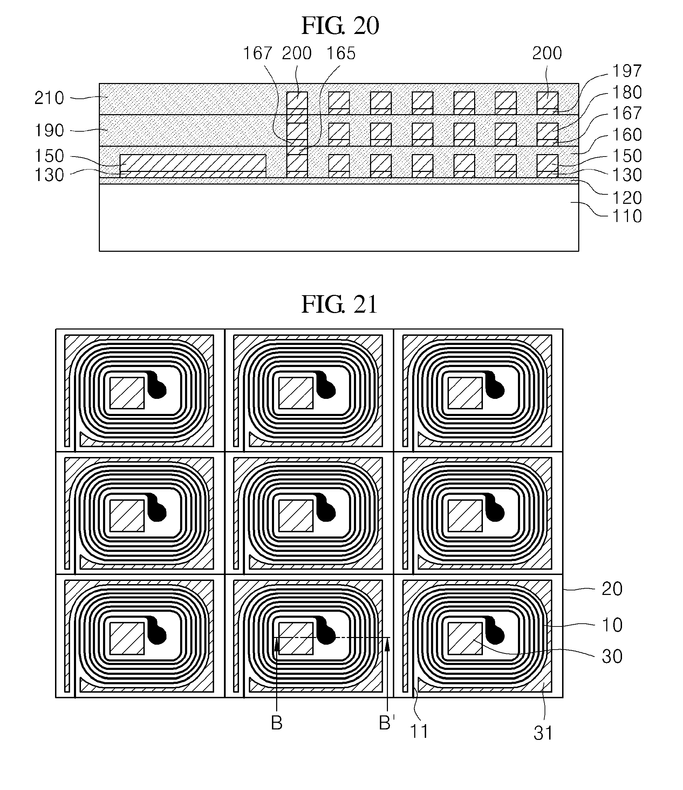

Referring to FIG. 20, after the coil patterns are stacked in a predetermined number, an insulating layer 210 is formed on the coil pattern and then the substrate is cut into unit devices along the cutting line. At this time, since the plating lead line 20 is formed overlapping the cutting line, the plating lead line 20 is removed when the substrate is cut into unit devices. Meanwhile, an ESD protection part 300 may be further formed before the substrate is cut into unit devices as illustrated in FIG. 11.

As described above, in another exemplary embodiment, the dummy pattern 30 is formed spaced apart from at least one coil pattern 10, e.g., the coil pattern 10a of the lower side. Since the dummy pattern 30 is formed in this way, a step difference between the region on which the coil pattern 10 is formed and the region on which the coil pattern 10 is not formed may be reduced. Therefore, a planarization process need not be performed after an insulating layer is formed on the dummy pattern. However, the dummy pattern 30 may be formed outside of the coil pattern 10 as well as formed spaced apart from a center region of the coil pattern 10. That is, as illustrated in FIG. 21, the dummy pattern 30 is formed spaced apart from a center portion of the coil pattern 10 and a dummy pattern 31 may be also formed on a region, in which the coil pattern 10 is not formed, between an outside of the coil pattern 10 and the cutting line of unit devices. As a result, the dummy patterns 30 and 31 may be formed on regions on which the coil pattern is not formed.

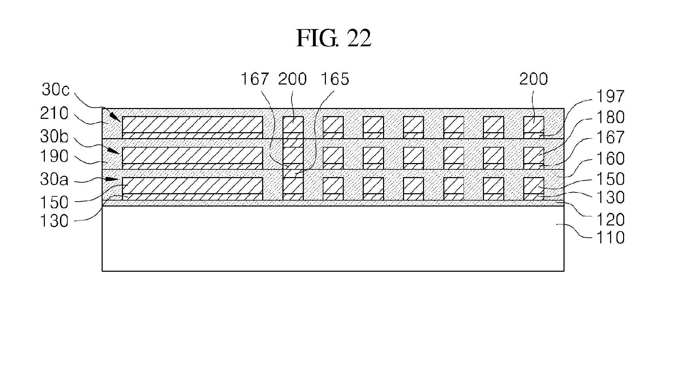

Meanwhile, in still another exemplary embodiment, the dummy pattern 30 is formed spaced apart from the first coil pattern 10a. That is, the dummy pattern 30 is formed spaced apart from at least one coil pattern 10a of a plurality of coil patterns 10 stacked in a vertical direction. However, when the stack number of the coil patterns 10 increases but only one dummy pattern 30 is formed, a step difference may occur. That is, when the stack number of the coil patterns 30 increases, only one dummy pattern 30 may not compensate for a step difference. Therefore, when a plurality of coil patterns 10 are formed, a plurality of dummy patterns 30 are preferably formed spaced apart from each of the coil patterns 30. A circuit protection device in accordance with a still another exemplary embodiment is illustrated in FIG. 22.

As illustrated in FIG. 22, a first insulating layer 120 is formed on a substrate 110, and a seed layer 130, a first coil pattern 10a by a first metal layer 140, and a first dummy pattern 30a spaced apart from the first coil pattern 10a are formed on the first insulating layer 120. As illustrated in another exemplary embodiment, a photosensitive layer pattern is formed on the seed layer 130, then an electroplating process is performed to form the first metal layer 140 from the seed layer 130, and the first dummy pattern 30a spaced apart from the first coil pattern 10a may be formed by eliminating the photosensitive layer pattern and then patterning the seed layer 130. In addition, a second insulating layer 160 is formed on the first coil pattern 10a and the first dummy pattern 30a, and a second coil pattern 10b and a second dummy pattern 30b by the second metal layer 180 is formed spaced apart from each other on the second insulating layer 160. At this time, a seed layer (not shown) is formed on the second insulating layer 160, then a photosensitive layer pattern is formed on the seed layer, an electroplating process is performed to form a second metal layer 180 from the seed layer, and the second dummy pattern 30b spaced apart from the second coil pattern 10b may be formed by eliminating the photosensitive layer pattern and then patterning the seed layer. In addition, a third insulating layer 190 is formed on the second coil pattern 10b and the second dummy pattern 30b, and a third coil pattern 10c and a third dummy pattern 30c by the third metal layer 200 are formed spaced apart from each other on the third insulating layer 190. The coil pattern 10 and the dummy pattern 30 are stacked spaced apart from each other in plurality in this way and then an insulating layer 210 is formed on the coil pattern 10 and the dummy pattern 30.

As described above, since the still another exemplary embodiment requires that the dummy pattern 30 be formed spaced apart from the coil pattern 10, the plating lead line 20 described in the exemplary embodiment and the another exemplary embodiment is not used and the metal layers, in particular, the second, and the third metal layers 180 and 200, for forming the coil pattern 10 and the dummy pattern 30, may be formed by an electroplating process after the seed layer is formed. Of course, it is possible that a metal layer is first formed by CVD, sputtering, or a printing method without performing a seed layer forming process and an electroplating process, and then is patterned by using a photoresist layer pattern to form a plurality of coil patterns and a dummy pattern spaced apart from the plurality of coil patterns.

As described previously, in an exemplary embodiment, since an extension line and a plating lead line are formed so as to be connected to a coil pattern and power is applied through the plating lead line when the coil pattern of the lowest layer is formed, a via hole may be filled by an electroplating process using a coil pattern of a lower side. Accordingly, since the method does not perform a process of forming a seed layer for filling a via hole, the number of process and process time may be reduced to enhance productivity when compared to a related art in which a seed layer and a metal layer should be formed for filling a via hole.

In addition, in another exemplary embodiment, a dummy pattern is formed spaced apart from at least one coil pattern as formed. That is, a dummy pattern is formed between a region in which a coil pattern is formed and a region on which the coil pattern is not formed. Therefore, a step difference between the region in which the coil pattern is formed and the region on which the coil pattern is not formed may be reduced and accordingly a planarization process need not be performed after an insulating layer is formed and reliability of a lithography process may be enhanced.

Although the circuit protection device and method of manufacturing same have been described with reference to the specific embodiments, they are not limited thereto. Therefore, it will be readily understood by those skilled in the art that various modifications and changes can be made thereto without departing from the spirit and scope of the present invention defined by the appended claims.

## Claims

1. A method of manufacturing a circuit protection device, the method comprising:
forming a plating lead line and a first coil pattern connected to the plating lead line on a substrate;
forming an insulating layer on the first coil pattern and then forming a via hole exposing a portion of the first coil pattern;
applying power through the plating lead line to form a via plug filling the via hole from the first coil pattern; and
forming a second coil pattern connected to the via plug on the insulating layer.

2. The method of claim 1, wherein the plating lead line is formed in plurality on the substrate in one direction and in another direction perpendicular to the one direction.

3. The method of claim 1 or 2, wherein at least one coil pattern is stacked on the second coil pattern in a vertical direction and the plurality of coil patterns stacked in the vertical direction are arranged in plurality inside a region between the plating lead lines in a horizontal direction.

4. The method of any of the claims 1 to 3, wherein the plating lead line is formed so as to overlap a cutting line for cutting the substrate into unit devices.

5. The method of any of the claims 1 to 4, wherein the plating lead line is eliminated together with the cutting line when the substrate on which the coil pattern is formed is cut into the unit devices.

6. The method of any of the claims 1 to 5, further comprising forming an ESD protection part insulated from the coil pattern of the lowest layer or the uppermost layer under the coil pattern of the lowest layer or on the coil pattern of the uppermost layer.

7. The method of any of the claims 1 to 6, further comprising forming a dummy pattern spaced apart from at least one of the coil patterns.

8. The method of any of the claims 1 to 7, wherein the dummy pattern is formed on a region on which the coil pattern is not formed.

9. A circuit protection device comprising:
a plurality of coil patterns stacked on a substrate in a vertical direction;
a plurality of insulating layers each formed between the plurality of coil patterns and insulating the plurality of coil patterns;
a plurality of via plugs formed in the plurality of insulating layers and connecting the plurality of coil patterns to each other; and
a dummy pattern formed in at least one coil pattern,
wherein the via plugs are formed by filling a via hole provided in the insulating layer from the coil pattern of a lower layer by applying power through a plating lead line connected to at least one of the coil patterns.

10. The method of claim 9, wherein the dummy pattern is formed on a region on which the coil pattern is not formed.

11. The method of claim 9 or 10, further comprising an ESD protection part formed under the lowest insulating layer or on the uppermost insulating layer.
